# EUROPEAN PATENT SPECIFICATION

(11) **EP 1 410 489 B1**
(45) Date of publication and mention of the grant of the patent: **26.12.2007**
(21) Application number: 02758270.9
(22) Date of filing: 18.06.2002
(51) Int. Cl.: H02M 7/00, H05K 9/00, H05K 1/18

(54) **POWER CONVERTERS**
STROMWANDLER
CONVERTISSEURS DE PUISSANCE

(30) Priority: 18.06.2001 IE 20010567
(43) Date of publication of application: 21.04.2004
(73) Proprietor: Advanced Modular Solutions Limited, Dunboyne, County Meath (IE)
(72) Inventor: McCLEAN, Joseph, Dunboyne, County Meath (IE)
(74) Representative: McCarthy, Denis Alexis
(86) International application number: PCT/EP2002/007012
(87) International publication number: WO 2002/103887

(56) References cited:
- US-A- 2 553 324
- US-A- 4 089 049
- US-A- 4 661 792
- US-A- 5 150 046
- US-A- 5 293 145
- US-A- 5 615 091
- MCCLEAN J W: "INDUCTOR DESIGN USING AMORPHOUS METAL C-CORES" , IEEE CIRCUITS AND DEVICES MAGAZINE, IEEE INC. NEW YORK, US, VOL. 12, NR. 5, PAGE(S) 26-30 XP000831611 ISSN: 8755-3996 figure 3 page 26-27 page 28, left-hand column page 30, right-hand column
- HIGH POWER FACTOR PREREGULATOR, [Online] XP002216739 Retrieved from the Internet: <URL:http://www-s.ti.com/sc/ds/uc3854.pdf> [retrieved on 2002-10-07]

## Description

The present invention relates to power converters, particularly power factor controllers or continuous mode boost pre-regulators. Applications of such units include Power Supplies for PABXs, Base Stations, Servers, Welding Equipment, Industrial Printing, Industrial Photocopying, and General Industrial Equipment, UPS Power Factor Correction, and Battery Chargers.

Such units generally combine a transformer with electronic control circuitry and power electronic components. The kernel of such units is a "boost" inductor controlled by and control and switching circuitry to increase an input DC voltage to a higher output DC voltage; the input DC voltage is usually generated by a rectifier from an AC supply.

In designing such units, it is desirable to minimize the number of components required to achieve active power factor correction in an AC/DC or an AC/AC switched mode power supply. It is also desirable to minimize the emission of and susceptibility to electromagnetic radiation.

A further consideration is that such units are often bought in by the manufacturers of products such as those listed above. The manufacturers of the units therefore have to provide not a single design but a range of designs with, in particular, different power levels.

The prior art document JP11238410 A discloses a power converter unit comprising a printed circuit board, a transformer mounted on one side of the board, the transformer being mounted with its aperture perpendicular to the board, and a control circuit mounted on the other side of the board.

The present invention provides a power factor controller unit as defined in claim 1. Preferred embodiments are defined in the dependent claims. Any components which would create excessive electromagnetic interference (eg semi conductors) are preferably excluded.

The present design thus provides a module or package that maintains a constant small footprint as power levels increase; only the height of the module changes when power is increased. If a PSU designer wishes to use the module in higher power supplies, then the only dimension of the module that will change will be its height. The module has a fixed footprint that designers can "plug in" to all of their different power supplies, and gives them flexibility to then choose the optimum location for these other components in finalizing their design.

Although the control circuitry excludes components which require scaling for different power levels, there are few other constraints on it. Preferably, therefore, it also provides a variety of additional functions, including the following features:
a synchronizing input to allow the synchronization to an external switching circuit.
an inhibit/shutdown input to allow externally connected circuitry to shutdown the module.
a voltage adjust input to override the internal circuitry in controlling the output voltage.
an auxiliary DC voltage to power up connected circuitry.
These additional functions, such as Sync and Vaux, simplify the process of incorporating the present unit into existing non-power factor corrected power supplies.

The module may be coupled to an external inductor connected across power in power out to increase output power, an external bridge rectifier connected to the power in to allow the unit to accept AC voltage, and an external totem pole transistor configuration to drive larger mosfets. It is easy to incorporate the present unit in larger systems, and adding a handful of external components results in a fully functional power factor corrected front end.

Preferably a substantial part of the transformer side of the board carries a shield conductor, to minimize the effect of electromagnetic radiation emitted by the transformer.

In addition to any shielding which may be provided on the PCB between the transformer and the control circuitry, it is desirable to design the transformer to minimize its inherent emission of radiated electromagnetic interference.

According to another aspect of the invention, there is provided a transformer for a power converter unit in which the connections between the electrical windings are such that the high frequency/high voltage winding(s) is inside the low frequency/low voltage winding(s).

The effect of this is that the outer windings act as a Faraday shield for electromagnetic interference.

Preferably the windings are connected in series. Preferably also the external electric field generated by the inductor is also reduced by connecting the inside winding (the high voltage/high frequency winding) to the drain of the boost mosfet of the surrounding circuitry.

A power supply unit embodying the invention will now be described by way of example and with reference to the drawings, in which:
Fig. 1 is a circuit diagram of typical power stage circuitry;
Fig. 2 is a circuit diagram of the control circuitry;
Figs. 3A and 3B show the printed circuit board (PCB);
Fig. 4 is a rough perspective view of the unit; and
Fig. 5 is a diagram of the transformer windings.

The present unit is a power factor controller with integrated boost choke (transformer). Combining this component with an external bridge rectifier, mosfet, diode, electrolytic capacitor, and current sense resistor results in a power supply with AC input (90V-270V AC) and a DC output (385-405V DC) being obtainable. This power supply exhibits a near unity power factor, ie both input voltage and current will be in phase and sinusoidal.

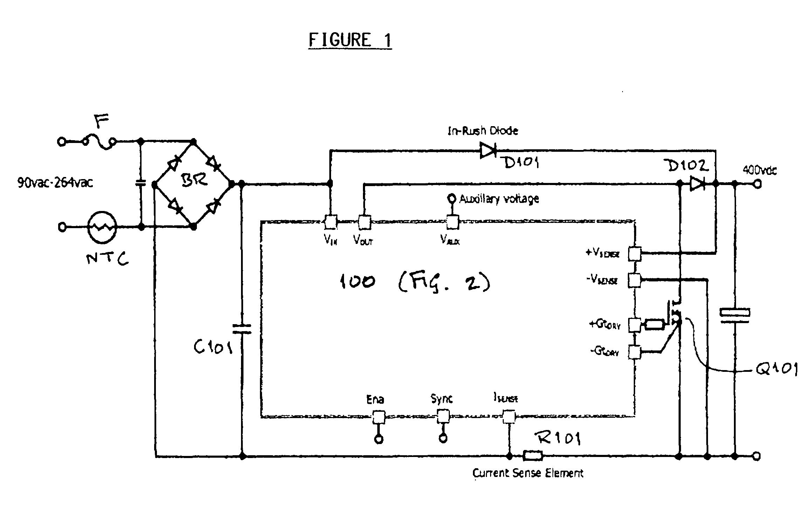

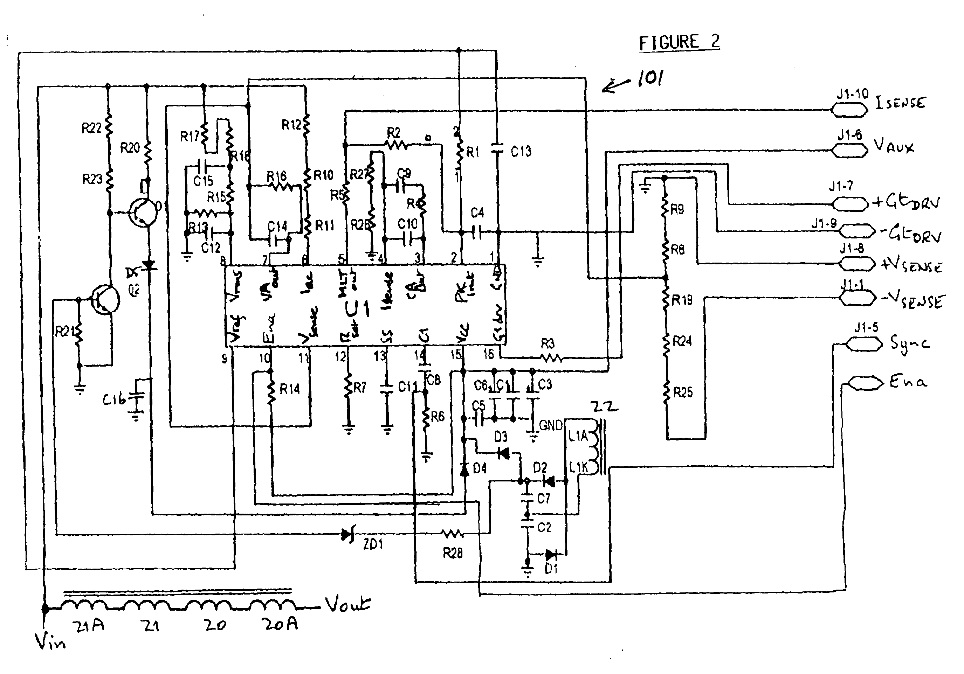

Fig. 1 shows typical power stage circuitry in which the present control unit may be used. This power stage circuitry comprises a bridge BR, an inrush diode D101, a diode D102, a switching transistor Q101, a current sense resistor R101, and a capacitor C101. This circuitry, together with the circuitry 100 shown in Fig. 2, forms an AC-to-DC power supply in which power factor is almost unity, ie Vac and Iac are in phase and sinusoidal. The circuitry 100 compares the voltages at +Vsense, Isense, and Vin and controls Q101 so that the current drawn into the power supplier Iac is a sinusoidal AC current in phase with Vac. Vaux is provided to power external DC circuitry if desired. Ena is provided to allow remote shut down / start up of the circuitry. Sync is provided in order to allow the switching rate of Q101 to be synchronize with an external frequency.

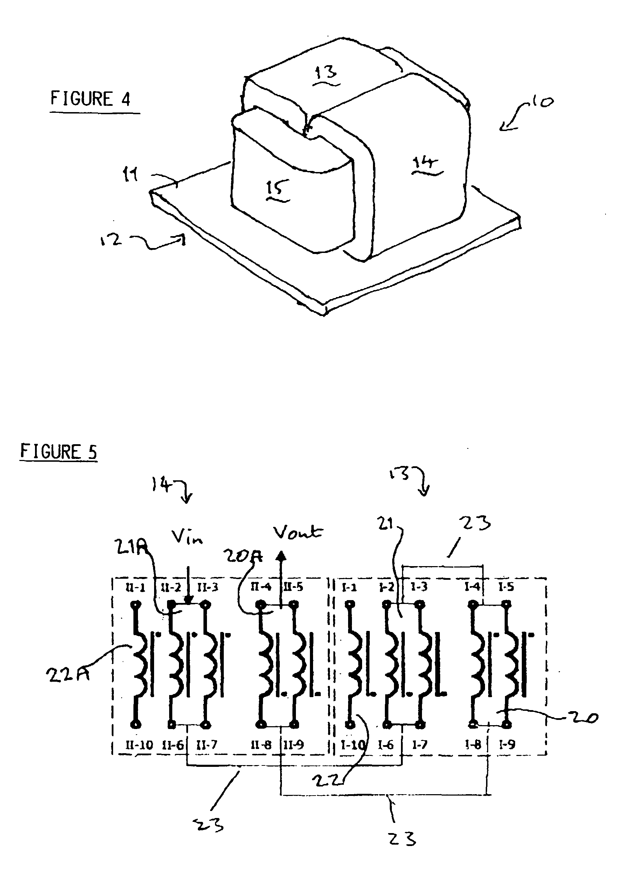

The structure of the module comprises a C core transformer placed on top of a printed circuit board. The module excludes specific components which would require an alteration of the footprint (length and width) as the power level is increased. Fig. 4 shows the general structure of the unit in simplified form. A transformer 10 is mounted on the upper side of a PCB 11, which has control circuitry 12 (not visible in the drawing) mounted on its other side. The transformer has two bobbins 13 and 14 carrying its windings, and a core 15 formed of 2 C-shaped elements. The aperture through the core is 12 x 42 mm, and the thickness of the core material is 12 mm. The aperture is oriented perpendicular to the board 10, and the height of the core is between 8 and 20 mm depending on the power rating of the unit (between 1 to 3 kW). (All dimensions are of course approximate.)

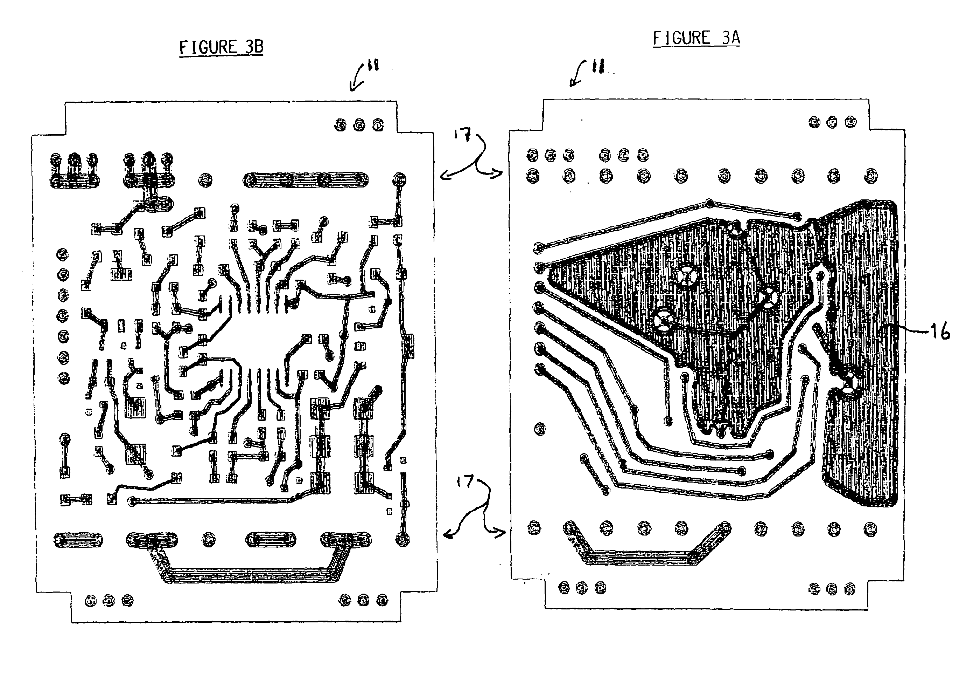

Fig. 3A shows the transformer side of the PCB 11, and Fig. 3B shows its control circuit side. The transformer terminals are connected to the two horizontal rows 17 of large terminals close to the upper and lower edges of the board. The large dark area 16 on the transformer side of the board covers a substantial part of the board and forms a shield between the transformer and the circuitry on the other side of the board. The details of the board layout are otherwise broadly conventional.

The present transformer core is designed to maximum the surface area to volume ratio. The volume of the transformer core generates losses, which in turn cause the temperature of the core to increase (the temperature rise being proportional to losses generated divided by surface area). So by maximizing surface area to volume ratio, a lower temperature rise is achieved. The problem to be solved is to increase the amount of power which can be got from the transformer (which is limited by the surface area of the transformer core). This is achieved by making a flatter transformer, thereby increasing surface area for a given weight and volume of transformer core. The present transformer achieves a power throughput of 1500 W with a core of 110 g compared to the standard 150 g of iron used by other suppliers. This allows the use of smaller components that can fit onto a footprint that is the same length and width of the core dimensions.

The present winding arrangement also minimizes losses through the length of the copper wire wound around the iron core.

The transformer consists of windings connected in series. One end of the transformer windings is connected to 50/60 Hz rectified AC voltage (peak value of voltage is 400 V); the other end of the winding is connected externally to the drain of a mosfet, which is switched on and off at a frequency of 45-50 kHz. The voltage of this end of the transformer winding changes between +400 V and 0 V very rapidly. This combination of high voltage and high frequency will radiate an electromagnetic field. To minimize this, the transformer windings are wound in layers keeping the high voltage/high frequency end as the innermost layer, so that the low voltage/low frequency winding acts as a faraday shield to reduce the radiated electromagnetic field.

Fig. 5 is a diagram of the transformer windings. These are in the form of two identical bobbins 13 and 14, each containing 5 windings. However, in each bobbin, 2 pairs of windings are connected in parallel, so there are effectively only 3 windings per bobbin - 20, 21, and 22 for bobbin 13, and 20A, 21A, and 22A for bobbin 14. In bobbin 13, winding 22 is the outermost, winding 21 is the middle, and winding 20 is the innermost, in bobbin 14, winding 22A is the outermost, winding 21A is the middle, and winding 20A is the innermost. Further, windings 21A, 21, 20, and 20A are connected in series as shown by means of tracks 23 on the PCB. Winding 21A is connected to the Vin signal, and winding 20A to the Vout signal. Thus the Vout signal, which is high voltage and high frequency, is fed to the innermost windings 20A and 20, which are shielded by the middle windings 21A and 21. Windings 22 and 22A also effect a shielding function, and are utilized by the control circuit shown in Fig. 2.

The present unit has the following unique combination of functional connections:
Current/Power In (V_{IN})
Current/Power Out (V_{OUT})
Voltage Sense In (+V_{SENSE})
Voltage Sense Out (-V_{SENSE})
Current Sense (I_{SENSE})
Gate Drive In (+GT_{DRV})
Gate Drive out (-GT_{DRV})
Auxiliary DC power supply (V_{AUX})
High Frequency Synchronizing connection (SYNC)
Inhibit/shutdown (ENA)
Vout Adjust (V_{ADJ})

Fig. 2 shows the control circuitry 101. This consists of start-up circuitry, auxiliary DC voltage circuitry, Vac sense circuitry, Vdc sense circuitry, Iac sense circuitry, mosfet drive circuitry, enable circuitry, and sync circuitry. These functions can all be implemented by circuitry that is length and width independent, ie whose dimensions are not dependent on the power level of the unit.

The start-up circuitry is a pass transistor circuit comprising R20, R22, R23, Q1, D5, C16 ,Q2, and R21. When full wave rectified voltage is applied to the node of R20 and R22, Q1 will turned on, D5 will conduct and C16 will charge. When C 16 charges above the threshold voltage required to start the integrated circuit U1, U1 will compare +Vsense, -Vsense, CS, and Vrms, and will start the drive circuitry for the external mosfet gate drive signals Gtdrv+ and Gtdrv-. Once the mosfet Q101 starts to switch on and off, high frequency AC current will flow in the primary of the transformer. This primary AC will induce a voltage across the secondary of the transformer (LIN, LIA). As soon as the external mosfet starts switching, the start up circuitry becomes redundant. The unit is powered up by two sources Vstartup and VAUX which are logically ORed through diodes D4 and D3.

The auxiliary drive circuit components are D1, D2, C7, C2, ZD2, R29, Q3, C1, C3, and C6. They generate a DC voltage approximately equal to the Zener voltage of ZD2 at the emitter of Q3. When this voltage exceeds the voltage rating of ZD1, Q2 turns on which in turn causes Q1 to turn off, thereby eliminating any stress on components R23, R22, R20 and Q1.

The level of the rectified line voltage is measured using U1, R17, R18, C15, R15, R13, and C12. The output DC voltage is sensed through a potential divider comprised of R9, R8, R19 ,R24, and R25, and compared with an internal reference voltage inside U1 by a voltage amplifier inside U1. The amplitude and frequency gain of the voltage amplifier is set by R16 and C14. The desired input current wave shape is measured from the input voltage through R12, R10, R21, and U1 (pin 6). The input voltage is measured as above and squared internally in U1. The DC output voltage, the desired input current, and the input AC voltage are compared, and internal circuitry inside U1 decides how to pulse width modulate the mosfet Q101. This pulse width modulation sequence forces the current through the primary of the transformer to be full wave rectified sine wave in phase with the full wave rectified input voltage.

The present design is a compact solution providing high power density (> 0.3 W mm²), a high efficiency (>96%), a high power factor (>99%), low harmonic distortion (<5%), good line and load regulation (both <5%), and low EMI. In addition, it provides auxiliary DC, a voltage to power downstream converter, a sync pin to reduce beat frequencies, and a comprehensive range of power levels, and meets the appropriate standards. Measurements on a unit operated at a switching frequency of about 50 kHz and a power level of slightly over 1 kW, with an input voltage of 180 V and an output voltage of 375 V, gave an efficiency of 97-98%, a magnetic core temperature of less than 100 °C, and a control board temperature of about 70 °C (the ambient temperature being 25 °C). The gap between the cores was 0.8 mm, giving an inductance of 400 µH at 12.8 A.

In summary, a power converter unit is provided which comprises a transformer 10 mounted on one side of a PCB 11, with the control circuitry on the other side of the PCB. The circuitry excludes any components which require scaling for different power ratings, or which are excessively radiation emitting or sensitive; such components must be added externally to the unit. The transformer is mounted with its aperture perpendicular to the PCB, so that the unit has a fixed footprint regardless of its rating; only its height varies with rating. The transformer is wound with the high voltage/high frequency windings inside the other windings, which act as a shield for radiation from the former windings. The PCB also incorporates a Faraday shield.

It is to be understood that the invention is not to be limited to the specific details described herein, which are given be way of example only, and various modifications and alterations are possible without departing from the scope of the invention as defined by the claims.

## Claims

1. A power factor controller unit comprising a printed circuit board (11), a transformer (10) mounted on one side of the board, the transformer being mounted with its aperture perpendicular to the board, and a control circuit (12, 101) mounted on the other side of the board, whereby the circuitry of the control circuit excludes components whose size is dependent on the power rating of the unit, ie require scaling for different power levels and the power factor controller unit maintains a constant footprint whereby only the height of the power factor controller unit changes as power levels increase.

2. A power factor controller unit according to claim 1 providing at least some of the following functions:
Current/Power In (V_{IN})
Current/Power Out (V_{OUT})
Voltage Sense In (+V_{SENSE})
Voltage Sense Out (-V_{SENSE})
Current Sense (I_{SENSE})
Gate Drive In (+GT_{DRV})
Gate Drive out (-GT_{DRV})
Auxiliary DC power supply (V_{AUX}) to power up connected circuitry
High Frequency Synchronizing connection (SYNC) to allow the synchronization to an external switching circuit
Inhibit/shutdown (ENA) shutdown input to allow externally connected circuitry to shutdown the module
Vout Adjust (V_{ADJ}) input to override the internal circuitry in controlling the output voltage.

3. A power factor controller unit according to either previous claim wherein a substantial part of the transformer side of the board carries a shield conductor (16).

4. A power factor controller unit according to any one of the previous claims wherein the connections between the electrical windings of the transformer (10) are such that the high frequency/high voltage windings (20, 20A) is inside the low frequency/low voltage windings (21, 21A, 22, 22A).

5. A power factor controller unit according to claim 4 wherein the windings are connected in series.

6. A power factor controller unit according to claim 4 or claim 5 wherein the inside winding, which is the high voltage/high frequency winding of the transformer, is connected to the drain of the boost mosfet of the surrounding circuitry.

7. A set of power factor controller units according to any one of the previous claims having different power ratings, wherein the printed circuit boards and control circuits are substantially identical and the transformers have different heights.

## Patentansprüche

1. Leistungsfaktorreglereinheit, umfassend eine Leiterplatte (11), einen an einer Seite der Platte montierten Transformator (10), wobei der Transformator mit seiner Öffnung senkrecht zu der Platte montiert ist, und einen an der anderen Seite der Platte montierten Steuerstromkreis (12), wobei die Schaltungen des Steuerstromkreises Komponenten ausschließen, deren Größe von der Nennleistung der Einheit abhängig ist, d.h. eine Größenveränderung für verschiedene Leistungshöhen erfordert, und die Leistungsfaktorreglereinheit eine konstante Anschlussfläche beibehält, wobei sich bei zunehmenden Leistungshöhen nur die Höhe der Leistungsfaktorreglereinheit ändert.

2. Leistungsfaktorreglereinheit nach Anspruch 1, die mindestens einige der folgenden Funktionen bereitstellt:
Strom/Leistung Ein (V_{IN})
Strom/Leistung Aus (V_{OUT})
Spannungssinn Ein (+V_{SENSE})
Spannungssinn Aus (-V_{SENSE})
Stromsinn (I_{SENSE})
Gateantrieb Ein (+GT_{DRV})
Gateantrieb Aus (-GT_{DRV})
Wechselstrom-Hilfszufuhr (V_{AUX}) zum Aufstarten angeschlossener Schaltungen
Hochfrequenz-Synchronisationsverbindung (SYNC), um die Synchronisation zu einem externen Schaltkreis zuzulassen Verhindern/Abschalt(ENA)-Abschalteingabe, um extern angeschlossenen Schaltungen das Abschalten des Moduls zu gestatten
Vout-Einstell(V_{ADJ})-Eingabe zum Umgehen der internen Schaltungen bei der Steuerung der Ausgangsspannung.

3. Leistungsfaktorreglereinheit nach einem der vorhergehenden Ansprüche, wobei ein wesentlicher Teil der Transformatorseite der Platte einen Schirmleiter (16) trägt.

4. Leistungsfaktorreglereinheit nach einem der vorhergehenden Ansprüche, wobei die Verbindungen zwischen den elektrischen Wicklungen des Transformators (10) so sind, dass die Hochfrequenz-/Hochspannungswicklungen (20, 20A) sich innerhalb der Niederfrequenz-/Niederspannungswicklungen (21, 21A, 22, 22A) befinden.

5. Leistungsfaktorreglereinheit nach Anspruch 4, wobei die Wicklungen in Reihe geschaltet sind.

6. Leistungsfaktorreglereinheit nach Anspruch 4 oder 5, wobei die innere Wicklung, die die Hochspannungs-/Hochfrequenzwicklung des Transformators ist, an den Drain-Anschluss des Spannungserhöhungs-MOSFETs der umgebenden Schaltungen angeschlossen ist.

7. Satz von Leistungsfaktorreglereinheiten nach einem der vorhergehenden Ansprüche, mit verschiedenen Nennleistungen, wobei die Leiterplatten und Schaltkreise im Wesentlichen identisch sind und die Transformatoren unterschiedliche Höhen aufweisen.

## Revendications

1. Unité faisant office de régulateur du facteur de puissance, comprenant une carte de circuit imprimé (11), un transformateur (10) monté sur un côté de la carte, le transformateur étant monté avec son orifice perpendiculaire à la carte, et un circuit de contrôle (12, 101) monté sur l'autre côté de la carte, les circuits de montage du circuit de commande excluant des composants dont la dimension dépend de la puissance nominale de l'unité, c'est-à-dire qui requièrent une mise à l'échelle pour différents niveaux de puissance, et l'unité faisant office de régulateur du facteur de puissance maintenant une empreinte ou un encombrement constant par lequel seule la hauteur de l'unité faisant office de régulateur du facteur de puissance change lorsque les niveaux de puissance augmentent.

2. Unité faisant office de régulateur du facteur de puissance selon la revendication 1, procurant au moins certaines des fonctions suivantes :
courant/puissance entrée (V_{IN}) ;
courant/puissance sortie (V_{OUT}) ;
détection de tension entrée (+V_{SENSE}) ;
détection de tension sortie (-V_{SENSE}) ;
détection de courant (I_{SENSE}) ;
entraînement de porte logique entrée (+GT_{DRV}) ;
entraînement de porte logique sortie (-GT_{DRV}) ;
alimentation de secours en courant alternatif (V_{AUX}) pour la mise sous tension des circuits connectés ;
connexion de synchronisation haute fréquence (SYNC) pour permettre la synchronisation par rapport à un circuit de commutation externe ;
entrée d'inhibition/arrêt (ENA) pour permettre la mise à l'arrêt du module via des circuits connectés de l'extérieur ;
entrée de réglage de la vitesse de sortie (V_{ADJ}) pour l'annulation des circuits internes concernant leur commande de la tension de sortie.

3. Unité faisant office de régulateur du facteur de puissance selon l'une quelconque des revendications précédentes, dans laquelle une partie importante du côté de la carte où se trouve le transformateur porte un conducteur blindé (16).

4. Unité faisant office de régulateur du facteur de puissance selon l'une quelconque des revendications précédentes, dans laquelle les connexions entre les enroulements électriques du transformateur (10) sont telles que les enroulements haute fréquence/haute tension (20, 20A) sont disposés à l'intérieur des enroulements basse fréquence/basse tensions (21, 21A, 22, 22A).

5. Unité faisant office de régulateur du facteur de puissance selon la revendication 4, dans laquelle les enroulements sont montés en série.

6. Unité faisant office de régulateur du facteur de puissance selon la revendication 4 ou 5, dans laquelle les enroulements internes, qui représentent les enroulements haute tension/haute fréquence, du transformateur, sont connectés au drain du transistor à effet de champ de semiconducteur d'oxyde de métal (MOSFET) faisant office de survolteur des circuits environnants.

7. Jeu d'unités faisant office de régulateurs du facteur de puissance selon l'une quelconque des revendications précédentes, possédant différentes puissances nominales, dans lequel les cartes de circuits imprimés et les circuits de contrôle sont essentiellement identiques et les transformateurs possèdent des hauteurs différentes.
